(19) Europäisches Patentamt / European Patent Office / Office européen des brevets

(11) EP 2 761 312 B1

(12) EUROPEAN PATENT SPECIFICATION

(45) Date of publication and mention
of the grant of the patent:
14.10.2015 Bulletin 2015/42

(21) Application number: 13702769.4

(22) Date of filing: 25.01.2013

(51) Int Cl.:
G01R 31/08 (2006.01)    H02H 7/26 (2006.01)

(86) International application number:
PCT/EP2013/051450

(87) International publication number:
WO 2013/113627 (08.08.2013 Gazette 2013/32)

(54) **FAULT DETECTION IN SUBSEA POWER CABLES**

FEHLERERKENNUNG BEI UNTERWASSERSTROMKABELN

DÉTECTION D'ANOMALIES DANS DES CÂBLES ÉLECTRIQUES SOUS-MARINS

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 31.01.2012 EP 12000627

(43) Date of publication of application:
06.08.2014 Bulletin 2014/32

(73) Proprietor: Siemens Aktiengesellschaft
80333 München (DE)

(72) Inventor: RADAN, Damir
N-4317 Sandnes (NO)

(56) References cited:
WO-A1-2011/012146      WO-A2-99/58992
US-A1- 2009 088 989

**Description**

Field of the invention

The invention relates to fault detection in sub-sea power cables.

Background

Recently, there has been an increasing interest in offshore hydrocarbon production. Hydrocarbon wells can be located many miles from shore sites and in water depths reaching down to several thousand meters. Subsea pipelines can be used for transporting hydrocarbons from an offshore well to a production vessel or to an onshore site, or may be used for transporting hydrocarbons between different onshore sites separated by an offshore section.

In deep waters, the water temperature is relatively low, it may for example be between about -1 and +4 °C. When hydrocarbons are produced from a subsea well, they can comprise a fraction of water, and they furthermore will cool significantly upon reaching the seabed. This can lead to the formation of hydrates, which are generally a combination of pressurized hydrocarbon gas with water. This combination can at low temperatures form a hydrate, which is a solid material. Hydrates can restrict the flow within a pipeline, or may even completely plug the pipeline.

Methods are known in the art which use chemicals for preventing hydrate formation. Another method which is more effective is the increase of the temperature of the pipeline, for example by using direct electric heating (DEH). Such DEH system is for example known from WO 2004/111519, which uses a subsea single phase cable which is attached to two sides of a steel pipeline. A 50/60 Hz AC current is passed through the cable and the pipeline, and the pipeline is heated due to its electric resistance.

The power source is generally located at an onshore location or on board of a production vessel, and an example of such power source is described in WO 2010/031626. The pipeline section to be heated is a single phase load on the power supply arrangement.

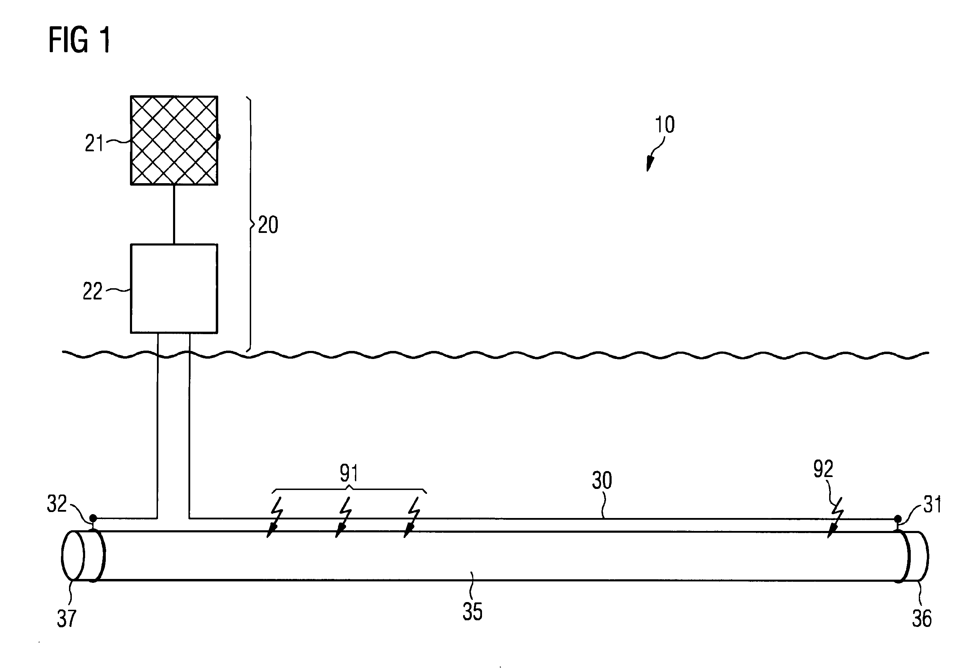

The detection and finding of the location of a fault in medium to high voltage subsea cables, in particular in subsea cables used in DEH systems is generally difficult. A single phase subsea cable may be used to supply the power to heated pipeline section and may be connected to anodes, see for example Fig. 1. As the subsea direct electric heating is an impedance based load, the voltage on the cable approaches zero at the remote location.

Previous methods used so far have generally limited accuracy for the detection of sub-sea faults at a far-remote location.

As the subsea direct electric heating is impedance based load, the voltage on the cable approaches zero at the remote location. This makes very difficult to use conventional methods of fault detection and location. Methods that may be used include:

1.) Inverse time-current curves; current is different for different loads; this makes it impractical to use one curve for each of the loads as e.g. 18 loads may be defined on existing DEH systems. Moreover, this method can be inaccurate for far remote faults as in such, the measured current in fault-less (normal) operations is relatively low (difficult to distinguish from a fault current).

2.) Impedance based protection where measured impedance Z = Voltage/Current is compared to find the reduction in impedance and thus the fault location proportional to load impedance. As the fault location can be located far away from the power source, a very small impedance change may only be detected. Errors in measuring equipment and calculations, and external influences to impedance value such as cable heating expansion may make this method impractical to use, in particular for the last 10% or 20% of the subsea cable length.

3.) Detection method based on fiber-optics, such as the ones described in WO 2007/096775 and WO 2010/108976, which relate to the use of a fiber optical relay for DEH subsea cable protection, based on fiber-optics build inside the cable insulation. Yet the optical fibers must be installed when the sub-sea cable is being produced, and the system is thus not suitable for existing installations. It is also complex and expensive. If the fiber-optics get damaged or burned inside the cable, the detection system can not be used any more and a new cable needs to be installed. This may pose a problem as subsea cables are among the most expensive equipment.

Further, although fiber-optical detection methods can be very fast in fault detection, they are generally not very suitable for finding the fault location, as existing detection methods are all based on detecting changes in the cable temperature, assuming the increase of cable temperature will lead to burn-ing of the cable. This assumption does not seem to be adequate, as the cable temperature may be different at locations at which the cable and the pipeline are buried in the ground and at which it is not buried but cooled with surrounding seawater.

Furthermore, the following protection methods and systems are known:

The document WO 2011/012146 A1 discloses a system for monitoring a cable system for the transmission of electric energy which comprises a cascade of monitoring nodes. The document describes the transmission of data from the individual monitoring nodes to a central unit.

The document US 2009/088989 A1 relates to systems and methods for detecting faults in power transmission systems. A set of current measurements is transmitted from a remote intelligent electronic device (IED) to a local IED. The current measurement comprises a timestamp to allow the local IED to time align the local current measurement with the remote current measurement.

The document WO 99/58992 A2 discloses a power cable monitoring system comprising one or more transducers distributed along the cable. Each transducer is operationally connected to the cable for measurement of operational parameters of the cable.

Summary

Accordingly, there is a need to obviate at least some of the drawbacks mentioned above and to provide an improved detection of faults in a subsea power cable.

This need is met by the features of the independent claims 1 and 5 The dependent claims describe embodiments of the invention.

An embodiment provides a method of detecting a fault in a subsea power cable or in a direct electric heating (DEH) system comprising a subsea power cable, wherein measuring points are distributed along the subsea power cable, the method comprising the steps of measuring at each measuring point a current in the subsea power cable; comparing the currents measured at the different measuring points; and detecting the presence and the location of a fault in the subsea power cable or in the DEH system based on the comparison.

By making use of different measuring points, it may become possible to determine the location of the fault from a remote location, so that a repair of the subsea power cable or the DEH system is facilitated and made more efficient. Further, it may become possible to detect faults even at the far end of the subsea power cable or of a pipeline section which is heated via power from the subsea power cable in a DEH system.

According to the invention, measuring the current at the measurement point comprises measuring the magnitude of the current or measuring the phase angle of the current, and the step of comparing the measured currents comprises comparing the measured current magnitudes or the measured phase angles.

According to the invention, measuring the phase angle of the current comprises measuring at each measuring point a voltage in the subsea power cable and determining the phase angle (or difference) between the voltage and the current. By making use of a phase difference, the detection of faults at a far end of the protected zone of the subsea power cable is facilitated, in particular since current magnitude may not change much during the occurrence of a fault at such position. Short circuit currents may be relatively low in case of a fault at a far end of the protected zone.

In an embodiment, the comparing of the phase angles for different measuring points may be done by comparing the phase differences between current and voltage, comparing current vectors, comparing polarities of the voltage measurements, or comparing directions derived for each measuring point from the current measurement, in particular from phase angle of the current measurement. In these examples, the comparison of the currents of two measuring points is based on the phase angle of the current (compared to the voltage at the respective measuring point).

Different advantageous possibilities may thus be implemented for performing the current comparison. In particular deriving a direction for each measuring point, preferably a direction pointing towards the fault, has the advantage that the evaluation of the fault location is facilitated.

The direction may point along the subsea power cable in one or the other direction and may be derived from a voltage polarity determined on the basis of the phase angle. In some embodiments, the derived direction may point along the subsea power cable in the direction of real power flow, and can be determined based on the current and voltage measurement at the respective measuring point. The derived directions may thus point to a sink constituted by the fault.

In an embodiment, the step of detecting the presence and the location of a fault in the subsea power cable or in the DEH system comprises using a directional protection scheme based on the measured currents for detecting the location of the fault. The scheme may further be based on voltages measured at each measuring point, in particular on a phase difference between current and voltage. Using a directional detection scheme may enhance the sensitivity for fault detection, in particular for remote faults.

In an embodiment, the method further comprises the step of transmitting information on the measured current from a measurement point to another measurement point, in particular to a neighbouring measurement point, and/or to a topside installation. The information may in particular be transmitted to a fault detection unit, which may e.g. be a protection relay located at a measuring point, in particular a master relay, or a subsea control module, or a topside fault detection unit.

An embodiment of the invention provides a fault monitoring system for a subsea power cable or for a direct electric heating system comprising a subsea power cable. The fault monitoring system comprises plural measuring units distributed along the subsea power cable and adapted to measure a current in the subsea power cable at corresponding measuring points by measuring a magnitude of the current, or by measuring at each measuring point the phase angle of the current by measuring a current and a voltage in the subsea power cable (30) and determining the phase angle between the voltage and the current, and a fault detection unit adapted to compare the current measurements of two or more measuring units by comparing the measured magnitudes of the current or by comparing the measured phase angles of the current and to detect the presence and the location of a fault in the subsea power cable or in the DEH system based on the comparison. Similar advantages as the ones outlined above with respect to the method may be achieved by such system.

In an embodiment, the fault monitoring system may further comprise a communication unit adapted to transmit information on currents measured at different measuring points to the fault detection unit. Information on measured currents may include phase angle or phase difference, a voltage polarity derived from such phase angle or a direction derived from the current measurement, as set out above.

In an embodiment, the fault monitoring system may comprise a communication unit adapted to transmit information on the presence and location of a fault to a topside installation. For example, at the topside installation, power to the subsea power cable may be cut in response to receiving such information.

In an embodiment, the fault detection unit is adapted to be located subsea. By performing the evaluation of the measurements subsea, the system may be made more efficient and/or compact. In particular, the fault detection unit may be a protection relay located at a measuring point, in particular a protection relay connected to a measuring unit, preferably a master relay. In another embodiment, the fault detection unit may be a subsea module in communication with protection relays located at the measuring points. Such subsea module may for example be implemented in a subsea control module.

In another embodiment, the fault detection unit may be located at a topside installation.

In an embodiment, the fault detection unit is adapted to compare the magnitude of the measured currents of the two or more measuring units. The current comparison may also be performed by comparing if a current was measured at all by the two or more measuring units. In case of a fault, measuring units and connected protection relays 'downstream' of the fault may no longer receive power. By detecting that these units do no longer provide information on current measurements (which may correspond to a current of zero), the fault detection unit may determine the presence and location of the fault. For the comparison, the fault detection unit may use information transmitted by the communication unit which can comprise current magnitude, on/off information about the measuring units, i.e. whether the measured current magnitude is above or below a given threshold. In an embodiment, the fault detection unit is adapted to compare the phase angle of the measured currents of the two or more measuring units.

As outlined above, comparing the phase angles does not need to be performed directly, but quantities or indicators derived from the phase angles may be compared. This may include comparing at least one of current vectors, directions derived from the phase angles (in particular a direction pointing towards the fault, e.g. the direction of real power flow), or voltage polarity of voltages measured by the two or more measuring units. The magnitude of the respective measurements may also be considered. The respective quantities can be communicated by means of a communication unit from the respective measuring point to the fault detection unit. Communicated information on current measurements may for example include phase angle, current vector or derived direction.

In an embodiment, the fault detection unit is adapted to detect the presence and location of a fault between two neighbouring measuring points if the direction derived at one measuring point points in one direction whereas the direction derived at the other measuring point points in a reverse direction. Both may for example point towards the fault. Detection of the fault location is thus facilitated.

In an embodiment, at each measuring point, a measuring unit, a protection relay and a communication unit are provided. The communication unit may be part of the protection relay.

In an embodiment, for each measuring point, the protection relay may be adapted to perform a current and a voltage measurement using the respective measuring unit. It may further be adapted to determine a direction on the basis of a phase difference between the measured current and voltage. As an example, the direction may point in the direction of real power flow. If a fault occurs upstream of a protection relay, the power flow at the respective measuring point may be reversed, leading to a change in polarity at a measuring voltage transformer of the measuring unit, which can be detected as a change in the phase difference (or phase angle) between voltage and current. The direction for this protection relay may thus be reversed, pointing towards the fault. The protection relay may further be adapted to communicate the determined direction to the fault detection unit, e.g. by using the communication unit.

In an embodiment, the measuring unit comprises a measuring current transformer mounted at the measuring point to the subsea power cable for measuring said current. It may furthermore comprise a measuring voltage transformer for performing a voltage measurement at the respective measuring point.

In an embodiment, the fault detection unit is adapted to compare the current measured by a measuring unit with the current measured by neighbouring measuring units.

In an embodiment, the fault detection unit is adapted to detect the presence and location of a fault if the current vector at one measuring point points in reverse direction whereas the current vector measured at a neighbouring measuring point points in forward direction.

In an embodiment, the fault monitoring system further comprises an energy storage coupled to the subsea power cable in proximity to a remote end thereof, in particular in proximity to a remote end of a pipeline section to be heated at which the subsea cable is electrically coupled to the pipeline section. If a fault occurs at the subsea power cable between measuring points, the measuring units and associated protection relays are enabled to measure a power flow from the energy storage towards the fault. This may make the determination of the fault location more precise. This may also ensure operability the downstream protection relays after such fault. The energy storage may be configured to supply electric power to the subsea power cable when the subsea power cable is in a de-energized state, i.e. before providing the main power to the subsea power cable or after fault (e.g. after the main power supply to the subsea power cable was cut). Measurements downstream of the fault (as seen from the main power source) may thus be enabled.

In an embodiment, a communication unit is provided for each measuring unit, wherein the communication units are adapted to communicate with each other using wireless communication or using a communication line, in particular a fibre optic communication line or power line communication via the subsea cable. One unit or each communication unit may be adapted to communicate with a topside installation, at which e.g. the fault detection unit or a protection device for disabling the main power supply to the subsea power cable may located, or to communicate with a subsea control module in which the fault detection unit may be located.

In embodiments of the invention, the fault monitoring system may furthermore be configured so as to perform any of the above outlined methods. Similarly, the above outlined methods may be performed on embodiments of the fault monitoring system.

It is to be understood that the features mentioned above and those yet to be explained below can be used not only in the respective combinations indicated, but also in other combinations or in isolation, without leaving the scope of the present invention. In particular, the features of the embodiments described above and those described hereinafter can be combined with each other unless noted to the contrary.

Brief description of the drawings

The foregoing and other features and advantages of the invention will become further apparent from the following detailed description read in conjunction with the accompanying drawings. In the drawings, like reference numerals refer to like elements.

Figure 1 is a schematic diagram showing possible locations of fault occurrences in a subsea power cable of a DEH system.

Figure 2 is a schematic block diagram of a fault monitoring system in accordance with an embodiment of the invention.

Figure 3 is a schematic block diagram of a fault monitoring system in accordance with an embodiment of the invention.

Figure 4 is a schematic block diagram of a fault monitoring system in accordance with an embodiment of the invention.

Figure 5 is a schematic block diagram of a fault monitoring system in accordance with an embodiment of the invention.

Figure 6 is a schematic block diagram of a fault monitoring system in accordance with an embodiment of the invention.

Detailed description

In the following, embodiments of the invention will be described in detail with reference to the accompanying drawings. It is to be understood that the following description of embodiments is given only for the purpose of illustration and is not to be taken in a limiting sense.

It should be noted that the drawings are to be regarded as being schematic representations only, and elements in the drawings are not necessarily to scale with each other. Also, the coupling of physical or functional units as shown in the drawings and described hereinafter does not necessarily need to be a direct connection or coupling, but may also be an indirect connection or coupling, i.e. a connection or a coupling with one or more additional intervening elements. A skilled person will further appreciate that the physical or functional units illustrated and described herein with respect to the different embodiments do not necessarily need to be implemented as physically separate units. One or more physical or functional blocks or units may be implemented in a common circuit, circuit element or unit, while other physical or functional blocks or units shown may be implemented in separate circuits, circuit elements or units.

Although the following description is given with respect to a subsea power cable of a direct electrical heating (DEH) system, it should be clear that the invention is equally applicable to other types of subsea power cables, e.g. to subsea power cables used to transport electric power to a subsea installation, e.g. to a subsea power grid or to transport electric power in such subsea power grid ot between components of a subsea installation. Other uses are certainly conceivable.

Figure 1 shows a DEH system 10. The DEH system 10 comprises a power system 21 which provides a main power source for direct electrical heating. Power system 21 may include a power grid, a generator or the like. The DEH system 10 further comprises a power supply system 22 for a subsea load. Power supply system 22 may for example comprise means for controlling the power flow into the subsea power cable ans well as protective means, e.g. circuit breakers.

Power system 21 and the power supply system 22 for a subsea load are both comprised in the topside installation 20. Note that in other configurations, power supply system 22 may be located at a subsea installation, it may e.g. be part of a subsea power grid.

The DEH system 10 is provided for heating several pipeline sections of a subsea pipeline for transporting hydrocarbons. In the example of Figure 1, an exemplary pipeline section 35 is shown. The power supply system 22 is coupled to both ends 36, 37 of the pipeline section 35. The subsea power cable 30 is part of said coupling and is used to transport electric energy to the far end 36 of the pipeline section 35. In operation, single phase AC voltage is applied to both ends 36, 37 of the pipeline section. Due to the conductivity and impedance of the pipeline section, current is conducted within the pipeline section 35 and heats the pipeline section. Thus the name 'direct electrical heating'.

In operation, faults may occur along the subsea power cable 91. Such faults can be located closed to the power supply system 22 (and thus to the main power source for the direct electrical heating), like faults 91, or they can be located further away (far-remote faults), like the fault 92. Faults include ground faults as well as faults resulting form an electrical contact between the subsea power cable 30 and the pipeline section 35 (of course other then the electrical connections provided at ends 36, 37). As can be seen, fault 92 is relatively close to the electric connection provided at end 36 of the pipeline section. Accordingly, the voltage drop caused by such fault is only small and the fault will be difficult to detect.

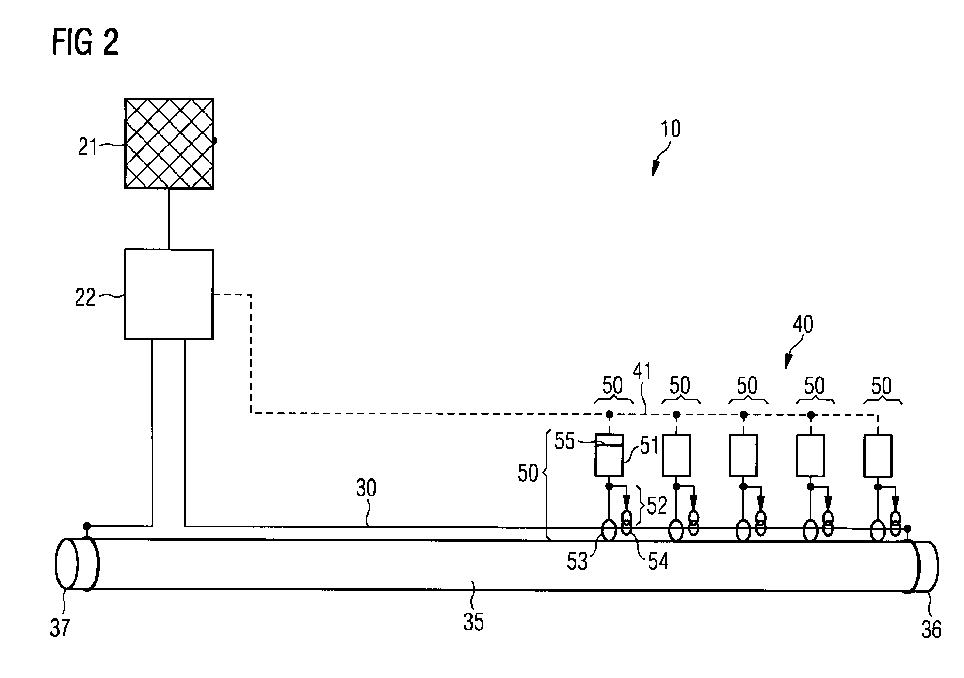

The problem of subsea cable fault detection and location presented above may be solved by using fault monitoring system 40 in accordance with an embodiment of the invention shown in Fig. 2, where a number of measuring transformers 53, 54 are located along the subsea power cable 30, in particular along the far remote part of the subsea power cable 30. The current transformers 53 are located at so called measuring points to measure current inside the subsea power cable 30. They are used to compare the currents in the individual segments between these measuring points.

Furthermore, a protection relay 51 and a communication unit 55, which may be part of the protection relay 51, are provided at each measuring point. The measuring current transformer 53 is considered to be part of a measuring unit 52. The communication unit 55, the protection relay 51 and the measuring unit 52 form a protection device 50. Such protection device is provided at several measuring points along the subsea power cable, in particular along its remote part in proximity to the remote end 36 of the pipeline section 35.

By means of the communication unit 55, the protection devices 50, in particular the protection relays 51 can communicate with each other and/or with an other device of e.g. a subsea installation or a topside installation using a communication link or line 41. Such communication line 41 may be provided by wireless communication, by optical communication (e.g. using a fiber optic cable) or by power line communication, e.g. using the subsea cable 30 as a power line, or using a dedicated power line provided for powering the protection relays 51.

In some embodiments, measuring unit 52 comprises only a measuring current transformer 53. In other embodiments, the measuring unit 52 may furthermore comprise a measuring voltage transformer 54.

A segment is hereinafter defined as a segment of the subsea power cable located between two measuring points, i.e. between two measuring devices 50.

The following are embodiments of detection methods which may be used with this arrangement:

> 1.) Current comparison between segments: based on monitoring of the current flow interruption after the last measuring point which will signify the fault location towards the right hand side of the power supply to the subsea power cable 30. The fault will generally be located towards the far end 36 of the pipeline section in the segment adjacent to the last protection relay 51 which measures a current in the subsea power cable 30 by means of the respective current transformer 53.
>
> 2.) Directional logical protection method for DEH: based on direction of vector currents (phasors) in individual segments - this protection scheme can for example operate when the DEH system is off-load and can be used prior or after energizing DEH. Location of a fault in a segment will lead to a change in voltage polarity for the protection relays 51 located between the fault and the far end 36 of the pipeline section 35. Electric power may for this purpose be injected at the far end of the subsea power cable 30 to enable a voltage measurement at such locations.

Note that apart from the subsea power cable of a DEH system, the system and method of the present invention may be used for detecting faults on any type of subsea power cable.

Several measuring points are located along the far-remote part of the subsea power cable 30 on the direct electric heating single phase system 10, as shown in Fig. 2. Each measuring point is equipped with a measuring current transformer 53 and/or a measuring voltage transformer 54, both can be used for current vector (magnitude and phase angle) measurement.

Measuring transformers 53, 54 may be fixed along the subsea cable, and are connected to the individual digital protection relays 51, which may be provided in a subsea box. Measuring transformers 53, 54 can be mechanically protected against water and can be placed either directly around the subsea power cable 30 or inside special mechanical protection tool. Such mechanical protection tools are available for providing mechanical protection to the subsea power cable.

Power supply for each protection relay 51 or protection device 50 can be provided by use of small transformers that can take power from the subsea power cable 30. The power consumption of protection relay 51 or protection device 50 is typically lower than 100 Watts, and thus relatively small. As the current in the subsea power cable 30 may be several hundred amperes, e.g. between 700 and 1600 A, and the transported power may range from 2 MW to 20 MW or more, it will generally be unlikely that the current used to power the protection devices 50 (relays 51) can be sensed as a current leak, as the power used for the protection relays 51 will be lower than 0,005% of the DEH load - this is generally lower than the measuring accuracy.

Each relay protection device can communicate between each other using wireless communication or communication via a communication line, e.g. a fiber optic cable or the above mentioned power line communication. The communication between devices will allow the detection of the fault and the sending of a signal to the topside installation, where this signal can trip the circuit breaker (e.g. comprised in power supply system 22) of the subsea load (here the pipeline section 35). The communication can be wireless, although optical communication, e.g. via fiber optic cable, is preferred since it is relatively resistant against electromagnetic disturbances.

Regarding the evaluation of the measurements, several implementations are conceivable. Each protection relay 51 may have be configured to perform a processing of measured data, e.g. deriving current magnitude, deriving a phase angle or current vector from measured current or voltage, determining current magnitude, determining voltage magnitude, determining voltage polarity (based on the phase angle of the current), determining the direction of real power flow (e.g. from the phase angle between voltage and current), determining a direction in which the fault is located (which may correspond to the direction of real power flow) and the like. All such information is directly derived from the current measurement and can thus be considered to represent the current. Comparing currents can thus involve the comparison of any of the above outlined derived quantities. Each of these quantities may be communicated to a fault detection unit which determines the presence and location of a fault from the received data.

The fault detection unit receives the information, compares the currents measured at the different measuring points and determines the presence and location of a fault (if such is present). As mentioned above, the comparison can comprise the comparison of any of the above outlined quantities, e.g. current magnitude, current phase angle, a polarity derived from the phase angle, a direction derived from the phase angle and the like.

The fault detection unit can be implemented in several ways. In some embodiments, it may be located subsea. The fault detection unit may be implemented by a respective functionality in each of the protection relays 51. In other embodiments, one protection relay 51 may act as a master relay and may implement the fault detection unit. This may for example be the protection relay located closest to the main power source 22. In further embodiments, the fault detection unit may be implemented in a subsea control module (SCM), which may be provided with such additional functionality.

In these embodiments, the fault detection unit is generally located in a subsea enclosure. It is further adapted to communicate with a topside installation (e.g. topside installation 20) so that it can, in case of the detection of a fault, transmit a signal for triggering circuit breakers or other protective equipment associated with the subsea power cable 30. In other embodiments, it may communicate with protective equipment located at the subsea installation, such as a sub-sea switchgear, for cutting the power to a faulty subsea power cable 30. Further damage to the subsea power cable 30 and connected equipment may thus be prevented.

In other embodiments, the fault detection unit may be located at the topside installation, e.g. in the power supply system 22. The protection relays 51 may then, via the respective communication units 55, transmit information on the measured currents (e.g. the above outlined quantities) to the fault detection unit via the communication link 41. The fault detection unit can the directly issue a trip command to a circuit breaker of the power supply system 22 for disconnecting the subsea power cable 30 in case of the occurrence of a fault.

A preferred implementation of the fault detection unit is within a protection relay 51 acting as a master relay. In the following description and in the figures, it is assumed that the fault detection unit is implemented in the protection relay 51, in particular in the one closest to the power supply system 22. It is configured to calculate the vector of currents based on a current measurement and voltage polarization, and it may be contained in a subsea canister and sealed against the ingress of sea water. It should be clear that the explanations given hereinafter are equally applicable to embodiments in which the fault detection unit is implemented in a SCM or at a topside installation.

One way of detecting the presence and location of a fault which may be used by the fault detection unit is the current comparison between segments.

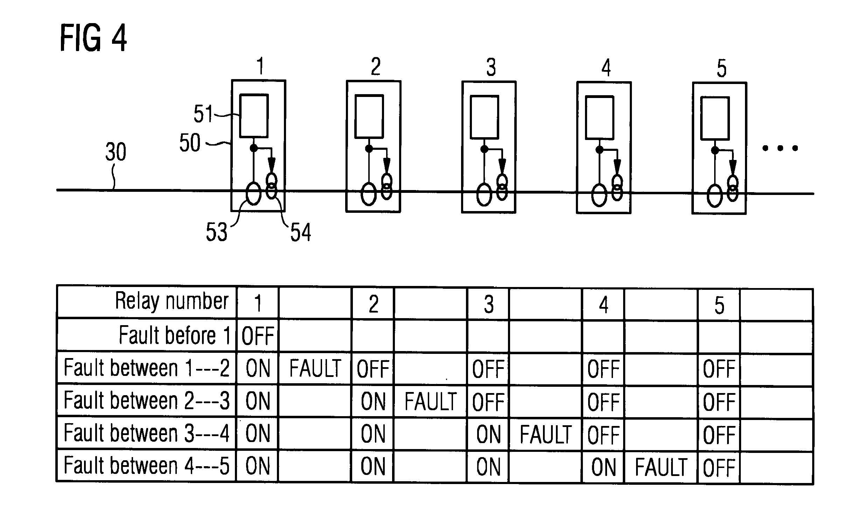

The logic is based on comparison of load currents in normal operations, not necessarily short-circuit currents as short circuit current may be very low when a far-remote fault occurs. The current at a single measuring location point in the system is compared by the fault evaluation unit with a neighboring measuring point. If the current is lower than the current on the other measuring point or zero, then the fault must be contained to the right hand side of the first location. The determination of fault location can be based on the logic matrix shown in figure 4. Moreover, if the current on all relays to the right hand side was reported lower than on the first relay to the left, this means that the fault must be contained in the right hand segment adjacent to the first relay.

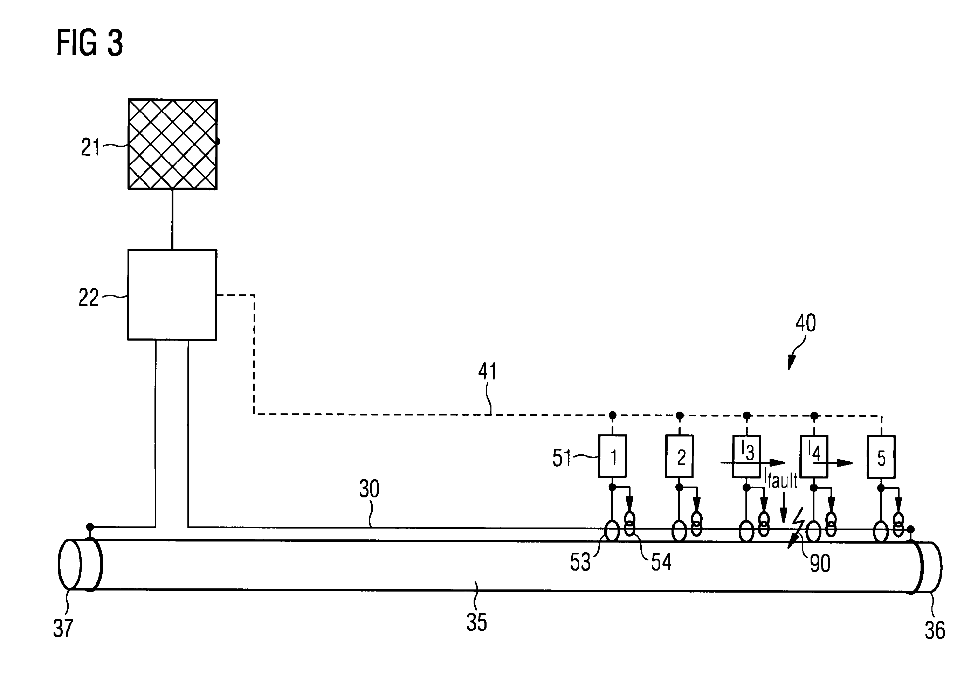

In figures 3 and 4, five protection relays 51 are provided, and they are designated by numerals 1-5. In the example of figure 3, relay 3 measures a current $I_3$ while relay 4 measures a current $I_4$. In case a fault occurs in the segment between relays 3 and 4, a fault current $I_{fault}$ will exist. The current measured by $I_4$ is then:

$$(1) \quad I_4 = I_3 - I_{fault}.$$

Thus, the fault location can be detected by the respective current measurements and can be determined by the fault evaluation unit, which may receive the current magnitude measured by the respective relay, an indication that the current magnitude is below or above a threshold, or an indication that no current was measured at all (e.g. be receiving no communication from the respective relay, i.e. the relay is 'off' and all current flows via the fault (fully bolted fault), so that the power supply to downstream relays is interrupted). In case of normal operation, $I_4$ equals $I_3$ and $I_{fault} = 0$.

Figure 4 shows an example of a logic for full bolted faults when all current is consumed by the fault and interrupted to other devices and supply. The figure further shows a table including a fault detection logic matrix which can be used to detect the fault location based on the current measurements.

The table in figure 4 illustrates how the fault location is detected based on information whether the respective protection relay is 'on' or 'off', i.e. measures a current or is cut off from the power supply. This may of course be implemented similarly by using current magnitudes, with a drop in current magnitude between two measuring point indicating the fault location, i.e. the faulty segment.

The protection relays 51 may have self-monitoring functions that can run self diagnostics and detect any faults inside the respective relay, so there is no need for an assumption that the relay failed to work (hidden failure inside relay) when an relay state 'off' is detected. Such assumption may thus not be used in the protection logic illustrated in figure 4.

Another way of detecting the presence and location of a fault which may be used by the fault detection unit is the directional logic method, which can also be used with DEH systems and subsea power cables.

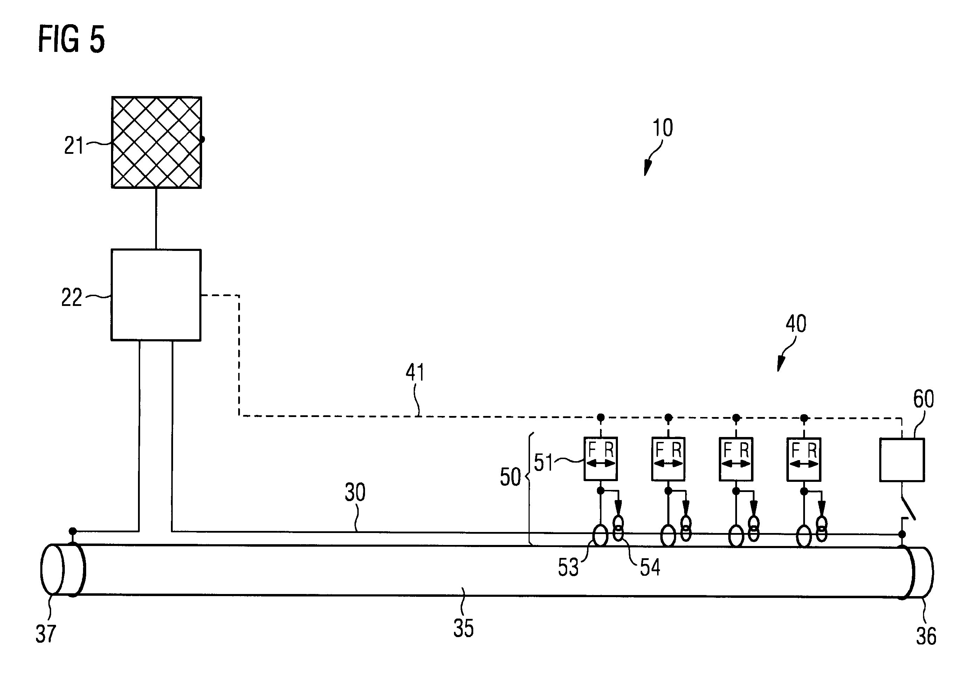

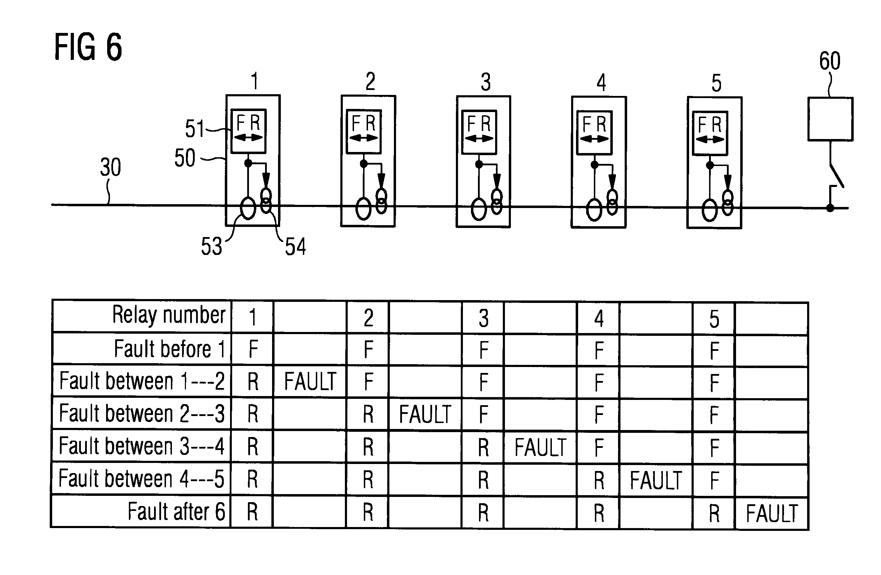

The detection method is based on the principle that even if the current magnitudes do not change much during the fault, the current phase angles will change. The protection relays may be programmed such that they determine a direction from the phase angle which points towards the direction of the fault (in figures 5 and 6 termed Reverse (R) or Forward (F)). This detection method is herein termed directional protection.

In a particular embodiment, each protection relay 51 may be configured to derive from a current can voltage measurement by means of measuring unit 52 to determine a direction of real power flow in the subsea power cable. In normal operation, real power flows away from the power supply 22 and towards the load (direction (R) in figures 5 and 6), here to the pipeline section 35. The direction of real power flow can be determined by the protection relay from the phase angle between voltage and current. If a fault occurs, the fault will constitute a sink towards which the real power will flow. Thus, the relays 'upstream' of the fault still determine a direction R towards the load and the fault, whereas the downstream relays determine an opposite direction F, which is pointing to the fault yet away from the load.

The logic is based on a comparison of load currents or test currents, not necessarily short-circuit currents as short circuit current may be very low when a far-remote fault occurs. The current vector at a single measuring point location in the system will be compared with neighboring measuring point. The fault is detected if one relay points Reverse (R) and neighboring relay points Forward (F). This is in detail illustrated in the Table logic presented in Fig. 6.

The logic will work if there is separate power source at each side of the fault, or pipeline. Typical DEH applications comprise a single power supply for a pipeline section. The power supply may be located close to the middle or to an end of the pipeline section. In any case, there will be at least one remote end of the pipeline section which in figures 5 and 6 is the right hand end 36. A fault may thus interrupt the power supply to a part of the subsea power cable leading to the remote end. At measuring point located at this part of the sub-sea power cable 30, no current and phase angle measurements can thus be performed.

However, this problem can be overcome. A low voltage energy storage 60, in form of e.g. battery, capacitor or similar, may be placed on the other side of the subsea cable, as presented in figure 5. This energy storage 60 can be connected after the occurrence of a fault after which the downstream part of the subsea power cable is de-energized (downstream meaning in a direction away from the power supply and towards the load). The energy storage thus allows a current and voltage measurement by the relays downstream of the fault. The energy storage 60 may comprise an inverter or the like for generating an AC output for the purpose of performing the measurement.

Also, after the occurrence of a fault, the upstream relays may no longer be able to make measurements, in particular when the power to the subsea power cable is cut. The protection relays 51 may thus comprise a memory in which they store past measurements, phase angle, current vector and/or the derived direction, i.e. R or F. The relays upstream of the fault will thus have stored the direction Reverse (R) before the system was tripped (disconnected). After the system is de-energized, it is possible to switch-on the low voltage energy storage 60 that can supply electric power to the subsea cable from the other side of the cable and thus, the downstream relay can determine the measuring points at which the current phasor or derived direction points in Forward (F) direction. Accordingly, the direction F or R can be determined for each measuring point. Based on the logic scheme presented in Fig.6, the location of the fault can be derived.

It should be clear that this is only an example of how the directional protection may be implemented. Other implementations are also conceivable, for example the determining of a current vector or current phasor at each measuring point and the comparing of these at the fault detection unit, or the like.

The embodiments of the invention described herein have several advantages. Faults can be detected with high speed and high sensitivity. The sensitivity to faults is in particular high since load currents can be compared, not only short-circuit currents (I>, I», I>>>) as in conventional relay protection methods. A high sensitivity to faults is also achieved since the signal is always compared by comparing values of similar current and voltage amplitudes at measuring points (current and voltage transformers), so that differences are relatively easy to detect. A high reliability can be achieved since the detection of false faults is reduced, it may be practically eliminated. Another advantage is the relatively easy setting of the system and the possibility to estimate the fault location subsea.

While specific embodiments are disclosed herein, various changes and modifications can be maid without departing from the scope of the invention. The present embodiments are to be considered in all respect as illustrative and non-restrictive, and all changes coming within the meaning and equivalency range of the appended claims are intended to be embraced therein.

## Claims

1. A method of detecting a fault in a subsea power cable (30) or in a direct electric heating, DEH, system (10) comprising a subsea power cable (30), wherein measuring points are distributed along the subsea power cable, the method comprising the step of

   - measuring at each measuring point a current in the sub-sea power cable (30),

   **characterized in that** measuring the current at each measurement point comprises measuring a magnitude of the current,
   or measuring at each measuring point the phase angle of the current by measuring a current and a voltage in the subsea power cable (30) and determining the phase angle between the voltage and the current, and **in that** the method further comprises the steps of

   - comparing the currents measured at the different measuring points by comparing the measured magnitudes of the current or by comparing the measured phase angles of the current; and
   - detecting the presence and the location of a fault in the subsea power cable or in the DEH system based on the comparison.

2. The method according to claim 1, wherein the step of comparing the measured phase angles for different measuring points comprises at least one of comparing the phase differences between current and voltage, comparing current vectors, comparing polarities of the voltage measurements, or comparing directions derived for each measuring point from the phase angle of the current measurements.

3. The method according to any of the preceding claims,
   wherein the step of detecting the presence and the location of a fault in the subsea power cable or in the DEH system comprises using a directional protection scheme based on the measured currents for detecting the location of the fault.

4. The method according to any of the preceding claims, further comprising the step of transmitting information on the measured current from a measurement point to another measurement point, in particular to a neighbouring measurement point, and/or to a topside installation.

5. A fault monitoring system (40) for a subsea power cable (30) or for a direct electric heating, DEH, system (10) comprising a subsea power cable (30), the fault monitoring system comprising:

   - plural measuring units (52) distributed along the subsea power cable and adapted to measure a current in the sub-sea power cable (30) at corresponding measuring points

   **characterized in that** the plural measuring units (52) are adapted to perform said measuring by measuring a magnitude of the current, or by measuring at each measuring point the phase angle of the current by measuring a current and a voltage in the subsea power cable (30) and determining the phase angle between the voltage and the current;
   and **in that** the fault monitoring system further comprises

   - a fault detection unit adapted to compare the current measurements of two or more measuring units (52) by comparing the measured magnitudes of the current or by comparing the measured phase angles of the current and to detect the presence and the location of a fault in the subsea power cable or in the DEH system based on the comparison.

6. The fault monitoring system according to claim 5, further comprising a communication unit (55) adapted to transmit information on currents measured at different measuring points to the fault detection unit.

7. The fault monitoring system according to claim 5 or 6, wherein the fault monitoring system (40) comprises a communication unit (55) adapted to transmit information on the presence and location of a fault to a topside installation (20).

8. The fault monitoring system according to any of claims 5-7, wherein the fault detection unit is adapted to be located subsea.

9. The fault monitoring system according to any of claims 5-8, wherein the fault detection unit is a protection relay (51) located at a measuring point or a subsea module in communication with protection relays (51) located at the measuring points.

10. The fault monitoring system according to claim 5 or 6, wherein the fault detection unit is located at a topside installation (20).

11. The fault monitoring system according to any of claims 5-10, wherein the fault detection unit is adapted to compare the current measurements by comparing phase angles of the measured currents of the two or more measuring units (52) by comparing at least one of current vectors, directions derived from the phase angles, or voltage polarity of voltages measured by the two or more measuring units.

12. The fault monitoring system according to claim 11, wherein the fault detection unit is adapted to detect the presence and location of a fault between two neighbouring measuring points if the direction derived at one measuring point points in one direction whereas the direction derived at the other measuring point points in a reverse direction.

13. The fault monitoring system according to any of claims 5-12, wherein at each measuring point, a measuring unit (52), a protection relay (51) and a communication unit (55) are provided.

14. The fault monitoring system according to claim 13, wherein for each measuring point, the protection relay is adapted to perform a current and a voltage measurement using the respective measuring unit and to determine a direction on the basis of the phase difference between the measured current and voltage.

15. The fault monitoring system according to any of claims 5-14, wherein the measuring unit comprises a measuring current transformer (53) mounted at the measuring point to the subsea power cable, and preferably further comprises a measuring voltage transformer (54).

16. Direct electric heating, DEH, system (10) comprising a fault monitoring system (40) according to any of claims 5-15.

**Patentansprüche**

1. Verfahren zum Erkennen eines Fehlers in einem Unterwasserstromkabel (30) oder in einem System (10) der direkten Elektroheizung (DEH), umfassend ein Unterwasserstromkabel (30), wobei entlang des Unterwasserstromkabels Messpunkte verteilt sind, wobei das Verfahren den folgenden Schritt umfasst:

- Messen eines Stroms im Unterwasserstromkabel (30) an jedem Messpunkt,

**dadurch gekennzeichnet, dass** das Messen des Stroms an jedem Messpunkt das Messen einer Größe des Stroms oder das Messen des Phasenwinkels des Stroms an jedem Messpunkt durch Messen einer Stromstärke und einer Spannung in dem Unterwasserstromkabel (30) und Bestimmen des Phasenwinkels zwischen der Spannung und der Stromstärke umfasst,
und dadurch, dass das Verfahren folgende Schritte umfasst:

- Vergleichen der an den verschiedenen Messpunkten gemessenen Ströme durch Vergleichen der gemessenen Größen des Stroms oder durch Vergleichen der gemessenen Phasenwinkel des Stroms und
- Erkennen des Vorliegens und der Position eines Fehlers in dem Unterwasserstromkabel oder in dem DEH-System basierend auf dem Vergleich.

2. Verfahren nach Anspruch 1, wobei der Schritt des Vergleichens der gemessenen Phasenwinkel für verschiedene Messpunkte mindestens eines der Folgenden umfasst: Vergleichen der Phasendifferenzen zwischen Stromstärke und Spannung, Vergleichen von Stromvektoren, Vergleichen von Polaritäten der Spannungsmessungen oder Vergleichen von Richtungen, die für jeden Messpunkt aus dem Phasenwinkel der Stromstärkemessungen abgeleitet wurden.

3. Verfahren nach einem der vorhergehenden Ansprüche, wobei der Schritt des Erkennens des Vorliegens und der Position eines Fehlers in dem Unterwasserstromkabel oder in dem DEH-System das Verwenden eines direktionalen Schutzschemas basierend auf den gemessenen Strömen zum Erkennen der Position des Fehlers umfasst.

4. Verfahren nach einem der vorhergehenden Ansprüche, ferner den Schritt des Übertragens von Informationen zum gemessenen Strom von einem Messpunkt zu einem anderen Messpunkt, insbesondere zu einem benachbarten Messpunkt, und/oder zu einer übertägigen Installation umfassend.

5. Fehlerüberwachungssystem (40) für ein Unterwasserstromkabel (30) oder ein System (10) der direkten Elektroheizung (DEH), das ein Unterwasserstromkabel (30) umfasst, wobei das Fehlerüberwachungssystem Folgendes umfasst:

 - mehrere Messeinheiten (52), die entlang des Unterwasserstromkabels verteilt und dafür eingerichtet sind, an entsprechenden Messpunkten einen Strom in dem Unterwasserstromkabel (30) zu messen,

**dadurch gekennzeichnet, dass** die mehreren Messeinheiten (52) dafür eingerichtet sind, das Messen durch Messen einer Größe des Stroms oder durch Messen des Phasenwinkels des Stroms an jedem Messpunkt durch Messen einer Stromstärke und einer Spannung in dem Unterwasserstromkabel (30) und Bestimmen des Phasenwinkels zwischen der Spannung und der Stromstärke auszuführen, und dadurch, dass das Fehlerüberwachungssystem ferner Folgendes umfasst:

 - eine Fehlererkennungseinheit, die dafür eingerichtet ist, die Strommessungen von zwei oder mehr Messeinheiten (52) durch Vergleichen der gemessenen Größen des Stroms oder durch Vergleichen der gemessenen Phasenwinkel des Stroms zu vergleichen und das Vorliegen und die Position eines Fehlers in dem Unterwasserstromkabel oder in dem DEH-System basierend auf dem Vergleich zu bestimmen.

6. Fehlerüberwachungssystem nach Anspruch 5, ferner eine Kommunikationseinheit (55) umfassend, die dafür eingerichtet ist, Informationen zu Strömen, die an verschiedenen Messpunkten gemessen wurden, zur Fehlererkennungseinheit zu übertragen.

7. Fehlerüberwachungssystem nach Anspruch 5 oder 6, wobei das Fehlerüberwachungssystem (40) eine Kommunikationseinheit (55) umfasst, die dafür eingerichtet ist, Informationen zum Vorliegen und zur Position eines Fehlers zu einer übertägigen Installation (20) zu übertragen.

8. Fehlerüberwachungssystem nach einem der Ansprüche 5 bis 7, wobei die Fehlererkennungseinheit dafür eingerichtet ist, unterseeisch angeordnet zu sein.

9. Fehlerüberwachungssystem nach einem der Ansprüche 5 bis 8, wobei die Fehlererkennungseinheit ein Schutzrelais (51) ist, das an einem Messpunkt oder einem Unterwassermodul in Kommunikation mit Schutzrelais (51) angeordnet ist, die an den Messpunkten angeordnet sind.

10. Fehlerüberwachungssystem nach Anspruch 5 oder 6, wobei die Fehlererkennungseinheit an einer übertägigen Installation (20) angeordnet ist.

11. Fehlerüberwachungssystem nach einem der Ansprüche 5 bis 10, wobei die Fehlererkennungseinheit dafür eingerichtet ist, die Strommessungen durch Vergleichen von Phasenwinkeln der gemessenen Ströme der zwei oder mehr Messeinheiten (52) durch Vergleichen mindestens eines der Folgenden zu vergleichen: Stromvektoren, aus den Phasenwinkeln abgeleitete Richtungen oder Spannungspolarität von Spannungen, die von den zwei oder mehr Messeinheiten gemessen wurden.

12. Fehlerüberwachungssystem nach Anspruch 11, wobei die Fehlererkennungseinheit dafür eingerichtet ist, das Vorliegen und die Position eines Fehlers zwischen zwei benachbarten Messpunkten zu erkennen, wenn die an einem Messpunkt abgeleitete Richtung in eine Richtung zeigt und die am anderen Messpunkt abgeleitete Richtung in eine entgegengesetzte Richtung zeigt.

13. Fehlerüberwachungssystem nach einem der Ansprüche 5 bis 12, wobei an jedem Messpunkt eine Messeinheit (52), ein Schutzrelais (51) und eine Kommunikationseinheit (55) bereitgestellt sind.

14. Fehlerüberwachungssystem nach Anspruch 13, wobei für jeden Messpunkt das Schutzrelais dafür eingerichtet ist, unter Verwendung der jeweiligen Messeinheit eine Stromstärke- und Spannungsmessung auszuführen und auf der Basis der Phasendifferenz zwischen der gemessenen Stromstärke und Spannung eine Richtung zu bestimmen.

15. Fehlerüberwachungssystem nach einem der Ansprüche 5 bis 14, wobei die Messeinheit einen Messstromtransformator (53) umfasst, der am Messpunkt an dem Unterwasserstromkabel montiert ist, und vorzugsweise einen Messspannungstransformator (54) umfasst.

16. System (10) der direkten Elektroheizung (DEH), das ein Fehlerüberwachungssystem (40) nach einem der Ansprüche 5 bis 15 umfasst.

**Revendications**

1. Un procédé de la détection d'une défaillance dans un câble d'alimentation électrique sous-marin (30) ou dans un système de chauffage électrique direct, DEH, (10) comprenant un câble d'alimentation électrique sous-marin (30), dans lequel des points de mesure sont répartis le long du câble d'alimentation électrique sous-marin, le procédé comprenant l'étape suivante :

   - la mesure au niveau de chaque point de mesure d'un courant dans le câble d'alimentation électrique sous-marin (30),

   **caractérisé en ce que** la mesure du courant au niveau de chaque point de mesure comprend la mesure d'une magnitude du courant, ou la mesure au niveau de chaque point de mesure de l'angle de phase du courant par la mesure d'un courant et d'une tension dans le câble d'alimentation électrique sous-marin (30) et la détermination de l'angle de phase entre la tension et le courant,
   et **en ce que** le procédé comprend en outre les étapes suivantes :

   - la comparaison des courants mesurés au niveau des différents points de mesure par la comparaison des magnitudes mesurées du courant ou par la comparaison des angles de phase mesurés du courant, et
   - la détection de la présence et de l'emplacement d'une défaillance dans le câble d'alimentation électrique sous-marin ou dans le système DEH en fonction de la comparaison.

2. Le procédé selon la revendication 1, dans lequel l'étape de comparaison des angles de phase mesurés pour différents points de mesure comprend au moins une comparaison parmi la comparaison des différences de phase entre courant et tension, la comparaison de vecteurs de courant, la comparaison de polarités des mesures de tension ou la comparaison de directions dérivées pour chaque point de mesure à partir de l'angle de phase des mesures de courant.

3. Le procédé selon l'une quelconque des revendications précédentes, dans lequel l'étape de détection de la présence et de l'emplacement d'une défaillance dans le câble d'alimentation électrique sous-marin ou dans le système DEH comprend l'utilisation d'un plan de protection directionnelle basé sur les courants mesurés pour la détection de l'emplacement de la défaillance.

4. Le procédé selon l'une quelconque des revendications précédentes, comprenant en outre l'étape de transmission d'informations relatives au courant mesuré d'un point de mesure à un autre point de mesure, en particulier à un point de mesure voisin, et/ou à une installation en surface.

5. Un système de surveillance de défaillances (40) pour un câble d'alimentation électrique sous-marin (30) ou pour un système de chauffage électrique direct, DEH, (10) comprenant un câble d'alimentation électrique sous-marin (30), le système de surveillance de défaillances comprenant :

   - une pluralité d'unités de mesure (52) réparties le long du câble d'alimentation électrique sous-marin et adaptées de façon à mesurer un courant dans le câble d'alimentation électrique sous-marin (30) au niveau de points de mesure correspondants,

   **caractérisé en ce que** la pluralité d'unités de mesure (52) sont adaptées de façon à exécuter ladite mesure par la mesure d'une magnitude du courant, ou par la mesure au niveau de chaque point de mesure de l'angle de phase du courant par la mesure d'un courant et d'une tension dans le câble d'alimentation électrique sous-marin (30), et la détermination de l'angle de phase entre la tension et le courant,
   et **en ce que** le système de surveillance de défaillances comprend en outre :

   - une unité de détection de défaillances adaptée de façon à comparer les mesures de courant de deux ou plus unités de mesure (52) par la comparaison des magnitudes mesurées du courant ou par la comparaison des angles de phase mesurés du courant et à détecter la présence et l'emplacement d'une défaillance dans le câble d'alimentation électrique sous-marin ou dans le système DEH en fonction de la comparaison.

6. Le système de surveillance de défaillances selon la revendication 5, comprenant en outre une unité de communication (55) adaptée de façon à transmettre des informations relatives à des courants mesurés au niveau de différents points de mesure à l'unité de détection de défaillances.

7. Le système de surveillance de défaillances selon la revendication 5 ou 6, dans lequel le système de surveillance de défaillances (40) comprend une unité de communication (55) adaptée de façon à transmettre des informations relatives à la présence et à l'emplacement d'une défaillance à une installation en surface (20).

8. Le système de surveillance de défaillances selon l'une quelconque des revendications 5 à 7, dans lequel l'unité de détection de défaillances est adaptée de façon à être installée sous la mer.

9. Le système de surveillance de défaillances selon l'une quelconque des revendications 5 à 8, dans lequel l'unité de détection de défaillances est un relais de protection (51) situé au niveau d'un point de mesure ou d'un module sous-marin en communication avec des relais de protection (51) situés au niveau des points de mesure.

10. Le système de surveillance de défaillances selon la revendication 5 ou 6, dans lequel l'unité de détection de défaillances se trouve au niveau d'une installation en surface (20).

11. Le système de surveillance de défaillances selon l'une quelconque des revendications 5 à 10, dans lequel l'unité de détection de défaillances est adaptée de façon à comparer les mesures de courant par la comparaison d'angles de phase des courants mesurés des deux ou plus unités de mesure (52) par la comparaison d'au moins un élément parmi des vecteurs de courant, des directions dérivées des angles de phase ou une polarité de tension de tensions mesurées par les deux ou plus unités de mesure.

12. Le système de surveillance de défaillances selon la revendication 11, dans lequel l'unité de détection de défaillances est adaptée de façon à détecter la présence et l'emplacement d'une défaillance entre deux points de mesure voisins si la direction dérivée au niveau d'un point des points de mesure est dans une direction tandis que la direction dérivée au niveau de l'autre point des points de mesure est dans une direction inverse.

13. Le système de surveillance de défaillances selon l'une quelconque des revendications 5 à 12, dans lequel, au niveau de chaque point de mesure, une unité de mesure (52), un relais de protection (51) et une unité de communication (55) sont installés.

14. Le système de surveillance de défaillances selon la revendication 13, dans lequel pour chaque point de mesure, le relais de protection est adapté de façon à exécuter une mesure de courant et de tension au moyen de l'unité de mesure respective et de façon à déterminer une direction en fonction de la différence de phase entre le courant et la tension mesurés.

15. Le système de surveillance de défaillances selon l'une quelconque des revendications 5 à 14, dans lequel l'unité de mesure comprend un transformateur de courant de mesure (53) monté au niveau du point de mesure sur le câble d'alimentation électrique sous-marin, et comprend de préférence en outre un transformateur de tension de mesure (54).

16. Un système de chauffage électrique direct, DEH, (10) comprenant un système de surveillance de défaillances (40) selon l'une quelconque des revendications 5 à 15.

FIG 1

# FIG 2

EP 2 761 312 B1

# FIG 3

# FIG 4

| Relay number | 1 | | 2 | | 3 | | 4 | | 5 | |
|---|---|---|---|---|---|---|---|---|---|---|
| Fault before 1 | OFF | | | | | | | | | |
| Fault between 1---2 | ON | FAULT | OFF | | OFF | | OFF | | OFF | |
| Fault between 2---3 | ON | | ON | FAULT | OFF | | OFF | | OFF | |
| Fault between 3---4 | ON | | ON | | ON | FAULT | OFF | | OFF | |
| Fault between 4---5 | ON | | ON | | ON | | ON | FAULT | OFF | |

EP 2 761 312 B1

FIG 5

# FIG 6

| Relay number | 1 | | 2 | | 3 | | 4 | | 5 | |
|---|---|---|---|---|---|---|---|---|---|---|
| Fault before 1 | F | | F | | F | | F | | F | |
| Fault between 1---2 | R | FAULT | F | | F | | F | | F | |
| Fault between 2---3 | R | | R | FAULT | F | | F | | F | |
| Fault between 3---4 | R | | R | | R | FAULT | F | | F | |
| Fault between 4---5 | R | | R | | R | | R | FAULT | F | |
| Fault after 6 | R | | R | | R | | R | | R | FAULT |

EP 2 761 312 B1

**EP 2 761 312 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004111519 A
- WO 2010031626 A
- WO 2007096775 A
- WO 2010108976 A
- WO 2011012146 A1
- US 2009088989 A1
- WO 9958992 A2